# EUROPEAN PATENT APPLICATION

(11) **EP 0 788 166 A2**
(43) Date of publication of application: **06.08.1997**
(21) Application number: 96309584.9
(22) Date of filing: 31.12.1996
(51) Int. Cl.: H01L 27/118, H01L 27/02

(54) **Integrated circuit chip having gate array book personalisation using local interconnect**

(30) Priority: 31.01.1996 US 595054
(71) Applicant: International Business Machines Corporation, Armonk, N.Y. 10504 (US)
(72) Inventor: Kemerer, Douglas Wayne, Essex Center, Vermont 05452 (US); Stout, Douglas Willard, Milton, Vermont 05460 (US)
(74) Representative: Moss, Robert Douglas

(57) **Abstract**

A gate array book layout for an integrated circuit chip is disclosed in which a local interconnect layer provides N-well and P-well contact straps extending substantially along the entire width of said gate array book across the top and bottom edges thereof. This enables efficient electrical connections between the various connection points located within the book. In particular, primarily vertical strips of local interconnect are used to connect contact points which exist at or near the same layer as the local interconnect layer. By using local interconnect in this manner, metal-1 layer usage is significantly reduced thereby allowing for a more efficient integrated circuit chip design.

## Description

### TECHNICAL FIELD

The present invention relates to the use of a local interconnect layer in semiconductor devices. More particularly, this invention relates to the utilization of the local interconnect layer in gate array cells.

### BACKGROUND OF THE INVENTION

One of the fundamental technologies available for allowing integrated circuit chip designers to place large numbers of logic circuits on a single or common very large scale integrated (VLSI) chip involves the use of gate array cells. Under this technology, rows of transistors are arranged in cells on the surface of the chip. A gate array cell on a complementary metal oxide semiconductor (CMOS) device typically comprises several transistors which will include an equal number of N-channel (NMOS) transistors and P-channel (PMOS) transistors. One or more gate array cells are typically grouped together in "gate array books" to form logic devices such as NAND or OR gates. Each gate array book is "personalized" (i.e., customized to perform a specific logic function) by interconnecting conductors between the various contact points found within the gate array book.

Contact points found within each gate array book include the source, drain and gates of each transistor, antenna-protection diodes, supply voltage (e.g., VDD) and ground requirements, N-well and P-well contacts, biasing connections, tie-offs, and diffusion areas. Gate array cells are discussed in some detail in U.S. Pat. No. 4,412,237 by N. Matsumura et al., filed on Dec. 11, 1978 and issued on Oct. 25, 1983, which is herein incorporated by reference.

An ongoing challenge faced by integrated circuit device manufacturers, including those which use gate array cells, is the desire to achieve more efficient circuit designs and provide for higher circuit densities. Because each individual gate array book will require many electrical interconnections between the various contact points of the gate array cells, interconnections inherently cause design limitations. This invention seeks to utilize the local interconnect layer as a means for interconnecting contact points in gate array books to achieve a more efficient design and high circuit density.

The local interconnect layer is a type of interconnect conductor traditionally used for connecting closely spaced elements in a layout design. Local interconnect exists on a layer below the standard metal layers (e.g., metal-1) and therefore proximate to both transistor gates (i.e., the "polysilicon") and the diffused silicon region. Many advanced semiconductor technologies utilize the local interconnect layer for direct connections to diffusion or polysilicon in order to achieve considerable density improvement in custom and standard cell structures. For example, U.S. Pat. No. 5,227,649 issued to Chapman on July 13, 1993, entitled "Circuit Layout And Method For VLSI Circuits Having Local Interconnects" discloses such a system in which local interconnect is utilized to bridge segments within an SRAM device. However, this local interconnect is not been within gate array books. Since gate array books may comprise a large percentage of a particular chip design, much of the benefit of the local interconnect layer may be lost without a gate array book layout that utilizes the interconnect layer.

The use of local interconnect conductors to personalize gate array books by connecting contact points to diffusion regions of transistors is shown in EP 0610771 A1.

The use of local interconnect within gate array books provides a significant improvement since many of the contact points required to personalize and power the gate array cells are found near the local interconnect layer.

The traditional means for interconnecting these various contact points has been to use the "metal-1" (M-1) layer. This method requires that a point-to-point connection must first run from a first contact point vertically up a contact opening to the M-1 layer, across the M-1 layer, and back down a contact opening to a second contact point. By using the local interconnect to connect certain contact points within gate array books (e.g., diffusion to diffusion), the need to go up to another layer is eliminated. The present invention seeks to minimize further the use of the M-1 level by utilizing the local interconnect layer as means for interconnecting gate array designs in a more efficient manner.

### DISCLOSURE OF INVENTION

The present invention provides a gate array book which includes at least one interconnection that utilizes the local interconnect layer to provide the necessary electrical connection by means of N-well and a P-well contact straps fabricated from said local interconnect conductor which run substantially the entire width of said gate array book across the top and bottom edges thereof. The placement of the contact strap at the top and bottom edges of the gate array allows for efficient fabrication in that it guarantees that a biasing conductor or tie-off fabricated from local interconnect will be available to any gate in the book. These additional interconnect conductors run in a primarily vertical direction, orthogonically to the straps.

Several preferred embodiments are disclosed in which local interconnect technology has been used in gate array layouts. For example, in addition to the N-well and P-well straps, a local interconnect layer may be used for an N-well and P-well biasing conductor, unused PMOS or NMOS transistor tie-offs and displacement of PMOS or NMOS diffusion contacts. It may also be used for connecting PMOS and NMOS gates to antenna protection diodes, PMOS gates to an antenna-protection diode and then to an NMOS gate, PMOS diffusion to NMOS diffusion, PMOS diffusion to an NMOS gate, and an NMOS diffusion to a PMOS gate. It is recognized these embodiments are merely examples of the possible gate array cell interconnections available within the scope of this invention. It should also be recognized that this invention is not necessarily limited to CMOS technology.

Thus, the present invention provides an integrated circuit chip which utilizes the local interconnect level for gate array cell connections and reduces usage of the metal-1 layer for gate array cell interconnections.

It is a further advantage of the present invention to leave more metal-1 tracks available for global wiring and to provide a personalization scheme wherein local interconnect primarily runs one direction while metal-1 runs primarily in an orthogonal direction.

### BRIEF DESCRIPTION OF DRAWINGS

The preferred exemplary embodiment of the present invention will hereinafter be described in conjunction with the appended drawings, where like designations denote like elements, and:
FIG. 1 depicts an unpersonalized gate array cell;
FIG. 2 depicts a gate array book forming part of an integrated circuit chip according to the invention and personalized using local interconnect to form a 3-way AND logic gate; and
FIG. 3 depicts a gate array book forming part of an integrated circuit chip according to the invention and personalized using local interconnect to form an XOR logic gate.

### DETAIL DESCRIPTION OF THE INVENTION

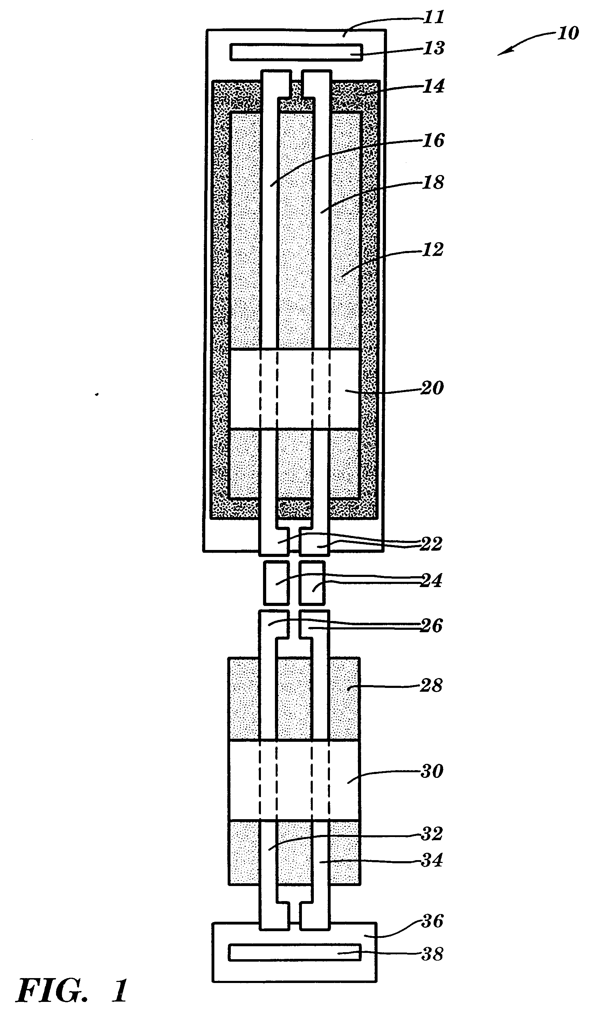

Referring now to the drawings, FIG. 1 depicts an unpersonalized gate array cell 10. The cell 10 includes two P-channel (PMOS) transistors 16 and 18 and two N-channel (NMOS) transistors 32 and 34. The P-channel transistors include polysilicon gate electrodes (polygates) 22 and a P-type source/drain diffusion region 12. Similarly, the N-channel transistors include polygates 26 and an N-type source/drain diffusion region 28. Other components on gate array cell 10 include N-well 11, N-well N+ diffusion 13, P+ implant 14, power (VDD) 20, ground (GND) 30, P+ implant 36, substrate P+ diffusion 38 and antenna-protection diodes 24. In general, those areas not within an N-well are a P-well and those diffusions which do not receive a P+ implant receive an N+ implant.

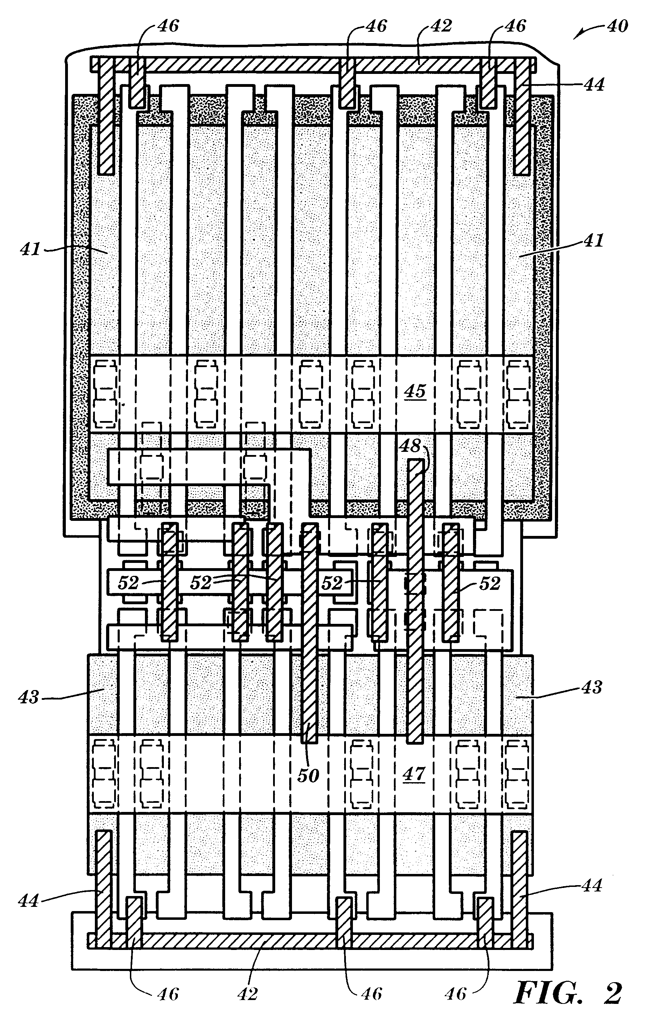

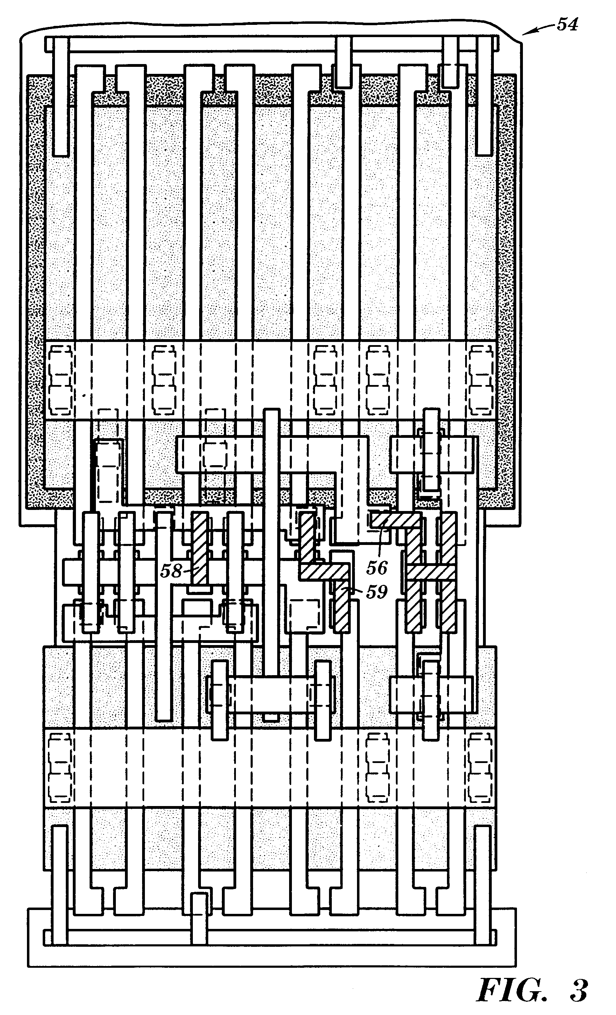

As shown, gate array cell 10 is not capable of performing any logic functions. In order to do so, the cell needs to be personalized (i.e., electrical interconnections between contact points within the cell and possibly electrical connections with other cells must be made). As previously mentioned, the traditional method for making such interconnections has been to utilize the metal-1 layer which limits the overall availability of the metal-1 layer. FIGS. 2 and 3 depict examples of how such interconnections can be made pursuant to the present invention using the local interconnect layer.

In FIG. 2, a gate array book is depicted personalized to form a 3-way AND logic gate 40 while FIG. 3 shows an XOR logic gate 54. As shown, various connections are depicted which utilize the local interconnect layer and therefore reduce the need to use the metal-1 layer. As depicted in FIG. 2, the left and right edges of book 40 end in P-channel (PMOS) 41 and N-channel (NMOS) 43 diffusions connected to VDD 45 and GND 47 respectively, which are shared with books placed horizontally adjacent (not shown).

Referring now to FIG. 2. a first category of locations where local interconnect can be used involves the area at the top and bottom of the gate array book 40. Local interconnect may be used for N-well and P-well contact straps 42 which connect adjacent N-well and P-well contact at the upper and lower edges of the cell 40. Contact straps 42 are also shared with gate array or standard cell books placed above or below a given book. Local interconnect may also be utilized with the local biasing interconnect 44 which connects diffusions to the N-well and P-well contact straps 42 in order to bias them to VDD and GND, respectively. A third location local interconnect may be used is for tie-offs 46 which comprise short segments of local interconnect to turn off any devices required for gate isolation. This is accomplished by connecting the gates of any PMOS isolation devices to the N-well contact strap (VDD) and any NMOS isolation devices to the P-well contact strap (GND). Collectively, the above three usages for local interconnect provide a significant fraction of the connections required in a gate array book without the use or blockage of any metal-1.

The second general category of connections where the local interconnect is utilized pursuant to this invention is in the area between the PMOS diffusion and the NMOS diffusion. This typically is the area where the logic input and output lines attach to the gate array book and many of the necessary interconnections are made. Pursuant to the embodiments shown in FIGS. 2 and 3, each gate array cell layout provides one antenna-protection diode between the inboard gate connections of each pair of PMOS and NMOS devices. This ratio allows any single device or vertically adjacent pair of devices to be defined as a book input with the addition of a short segment of local interconnect 52. (Many schemes cannot support a ratio this high and thus require book inputs to be spread out, potentially wasting devices and reducing density). Pursuant to the layouts shown in FIGS. 2 and 3, the gate array cells provide a personalization scheme where local interconnect primarily runs in one direction (vertically) and metal-1 connections run in an orthogonal direction (horizontally). The horizontal metal-1 wiring maximizes the metal-2 accessibility of pins and allows many pins to be accessed by metal-1 from the right and left edges of a book.

Referring now to FIG. 2, several examples of vertically running local interconnect are depicted within the area spanning the PMOS and NMOS diffusion regions. As shown, local interconnect may be used for gate-to-gate connections 52 that may connect a PMOS gate to an antenna-protection diode and further connect to an NMOS gate. Additionally, local interconnect may be used for PMOS to NMOS connections 48 between PMOS and NMOS source or drain diffusions. This type of connection spans the entire area between the two diffusion regions. Similarly, local interconnect may be used to displace a diffusion contact 50 into the area between the devices. The displacement 50 provides at least three vertically adjacent locations where connections to an orthogonal metal-1 wire may be made. In more complex designs, the PMOS and NMOS diffusion connections can each be displaced one track toward the other without being connected, thus providing a pair of cross-unders.

Referring now to FIG. 3, a gate array book personalized to form an XOR logic gate 54 is shown depicting further possible uses for local interconnect within a gate array book. Here, local interconnect 58 is used to connect a PMOS gate to an antenna protection diode. (Similarly, it would also be possible to have an NMOS gate connected to an antenna protection diode). Furthermore, it is possible, under certain circumstances to have the local interconnect run horizontally in this area. This is shown 59 as a PMOS gate connected to an antenna-protection diode, with a left-to-right jog, which is further connected to an NMOS gate. Furthermore, short jogs of local interconnect 56 allow connections between PMOS source or drain diffusions and NMOS gates. Similar jogs may be used to connect NMOS source or drain diffusions and PMOS gates.

While the exact materials and specifications for the implementation of this invention are not critical to its novelty, the local interconnect may be fabricated from robust damascene tungsten, such as that disclosed by F. While et al, in "Damascene Stud Local Interconnect in CMOS Technology," 1992 IEEE International Electron Devices Meeting Digest of Technical Papers, p.301, which is hereby incorporated by reference.

## Claims

1. An integrated circuit chip comprising a plurality of gate array cells (10) arranged side by side to form a gate array book (40), said gate array book having a plurality of contact points and being personalized to perform a logic function by means of a local interconnect conductor (48, 50, 52), characterised in that :-
said gate array book comprises an N-well and a P-well contact strap (42) fabricated from said local interconnect conductor and in that said N-well and P-well contact straps run substantially the entire width of said gate array book across the top and bottom edges thereof.

2. An integrated circuit chip as claimed in claim 1 wherein said gate array book comprises:
a plurality of P-channel transistors wherein each of said P-channel transistors includes a first plurality of contact points;
a plurality of N-channel transistors wherein each of said N-channel transistors includes a second plurality of contact points;
a third plurality of contact points located throughout said one gate array book; and
said local interconnect conductor provides electrical connections between at least two said contact points.

3. An integrated circuit chip as claimed in any preceding claim wherein said local interconnect conductor further comprises an N-well and a P-well biasing connection.

4. An integrated circuit chip as claimed in any preceding claim wherein said local interconnect connectors further comprises at least one unused transistor tie-off.

5. An integrated circuit chip as claimed in any preceding claim wherein said local interconnect conductor connects at least one transistor gate to an antenna-protection diode.

6. An integrated circuit chip of as claimed in any preceding claim wherein said local interconnect conductor connects a PMOS gate to an antenna-protection diode to an NMOS gate.

7. An integrated circuit chip as claimed in any preceding claim wherein said local interconnect conductor connects a PMOS diffusion to an NMOS diffusion.

8. An integrated circuit chip as claimed in any preceding claim wherein said local interconnect conductor effect a displacement of at least one diffusion contact.

9. An integrated circuit chip of as claimed in any preceding claim wherein said local interconnect conductor connects a PMOS diffusion to an NMOS gate.

10. An integrated circuit chip of as claimed in any preceding claim wherein said local interconnect conductor connects an NMOS diffusion to a PMOS gate.
